Europäisches Patentamt

European Patent Office

Office européen des brevets

(19)

(11) **EP 1 055 259 B1**

(12) **FASCICULE DE BREVET EUROPEEN**

(45) Date de publication et mention
de la délivrance du brevet:
**12.06.2002 Bulletin 2002/24**

(21) Numéro de dépôt: **99902633.9**

(22) Date de dépôt: **10.02.1999**

(51) Int Cl.7: **H01L 43/08**, H01F 10/08

(86) Numéro de dépôt international:
**PCT/FR99/00289**

(87) Numéro de publication internationale:
**WO 99/41792 (19.08.1999 Gazette 1999/33)**

(54) **MAGNETORESISTANCE A EFFET TUNNEL ET CAPTEUR MAGNETIQUE UTILISANT UNE TELLE MAGNETORESISTANCE**

TUNNELEFFEKT-MAGNETOWIDERSTAND UND ANWENDUNG EINES SOLCHEN MAGNETOWIDERSTANDS IN EINEM MAGNETISCHEN SENSOR

MAGNETORESISTOR WITH TUNNEL EFFECT AND MAGNETIC SENSOR USING SAME

(84) Etats contractants désignés:
**DE ES FR GB IT**

(30) Priorité: **11.02.1998 FR 9801616**

(43) Date de publication de la demande:
**29.11.2000 Bulletin 2000/48**

(73) Titulaire: **COMMISSARIAT A L'ENERGIE ATOMIQUE**
**75015 Paris (FR)**

(72) Inventeurs:
 • **DIENY, Bernard**
 **F-38170 Seyssinet (FR)**
 • **GIACOMONI, Laurence**
 **F-38000 Grenoble (FR)**
 • **VEDYAEV, Anatoly**
 **Moscou, 105215 (RU)**

(74) Mandataire: **Des Termes, Monique et al**
 **Société Brevatome**
 **3, rue du Docteur Lancereaux**
 **75008 Paris (FR)**

(56) Documents cités:
**US-A- 5 650 958**

• **RISHTON S A ET AL: "Magnetic Tunnel Junctions fabricated at tenth-micron dimensions by electron beam lithography" MICROELECTRONIC ENGINEERING, vol. 35, no. 1, février 1997, page 249-252 XP004054051**
• **GALLAGHER W J ET AL: "MICROSTRUCTURED MAGNETIC TUNNEL JUNCTIONS (INVITED)" JOURNAL OF APPLIED PHYSICS, vol. 81, no. 8, PART 02A, 15 avril 1997, pages 3741-3746, XP000702680**
• **LU Y ET AL: "SHAPE-ANISOTROPY-CONTROLLED MAGNETORESISTIVE RESPONSE IN MAGNETIC TUNNEL JUNCTIONS" APPLIED PHYSICS LETTERS, vol. 70, no. 19, 12 mai 1997, pages 2610-2612, XP000694770**
• **HWANG D G ET AL: "MAGNETORESISTANCE AND MORPHOLOGY IN MAGNETIC MULTILAYERS BY INSERTION OF VERY THIN FE, CO LAYERS" IEEE TRANSACTIONS ON MAGNETICS, vol. 32, no. 5, septembre 1996, pages 4579-4581, XP000634073**

**Description**

Domaine technique

La présente invention concerne une magnétorésistance à effet tunnel, encore appelée magnétorésistance "à vanne magnétique", et un capteur magnétique utilisant une telle magnétorésistance.

Les capteurs magnétiques sont sensibles à des champs ou à des flux magnétiques. Ainsi, le capteur magnétique, objet de l'invention, peut être utilisé, par exemple, pour la lecture d'informations inscrites sur des supports magnétiques de stockage de données. D'autre part, l'invention peut être mise à profit pour la réalisation de dispositifs à mémoire magnétique non volatile (Magnetic Random Access Memory).

Le capteur magnétique peut également être utilisé pour déterminer un courant électrique circulant dans un conducteur, en mesurant le champ magnétique régnant au voisinage de ce conducteur.

Enfin, d'autres applications du capteur magnétique, comme capteur de position ou comme boussole magnétorésistive, peuvent également être envisagées.

De façon plus générale, l'invention concerne tout type de capteur ou de magnétorésistance capable de détecter ou mesurer des champs magnétiques et notamment des champs faibles, c'est-à-dire dans une gamme allant de quelques A/m à quelques milliers d'A/m.

Etat de la technique antérieure

Récemment encore, les capteurs magnétorésistifs utilisés pour la détection de champs magnétiques faibles, notamment dans le domaine de l'enregistrement magnétique, étaient pour la plupart des capteurs basés sur un effet dit d'"'anisotropie de magnétorésistance".

L'effet d'anisotropie de magnétorésistance se manifeste dans les métaux de transition ferromagnétiques tels que les alliages à base de nickel, de cobalt ou de fer. Il consiste en une variation de la résistivité du matériau magnétique en fonction d'un angle existant entre un courant électrique de mesure circulant à travers le matériau et l'aimantation du matériau.

Le changement relatif de résistivité p du matériau magnétique, noté $\Delta\rho/\rho$ peut atteindre 4 à 5% à température ambiante pour des champs de l'ordre du kA/m et dans des métaux de transition ferromagnétiques massifs. Cette amplitude est néanmoins réduite à 1 ou 2% lorsque les mêmes matériaux sont déposés en couches minces avec des épaisseurs de 15 à 30 nanomètres. Cette gamme d'épaisseurs est celle utilisée pour la fabrication des capteurs magnétorésistifs actuels. La sensibilité de ces capteurs est donc limitée. Par ailleurs, leur réponse n'est pas linéaire. En effet, la variation de la résistivité est proportionnelle au carré du cosinus de l'angle entre le courant de mesure et l'aimantation.

On connaît par ailleurs des capteurs fonctionnant selon un effet dit de "magnétorésistance géante". Cet effet a tout d'abord été découvert pour des structures multicouches de type fer-chrome et par la suite pour d'autres systèmes multicouches formés d'une alternance de couches de métal de transition ferromagnétique et de couches de métal non-magnétique.

Dans ces systèmes, l'effet de magnétorésistance est essentiellement lié à un changement dans l'orientation relative des aimantations des couches ferromagnétiques successives. Cet effet est usuellement désigné par "magnétorésistance géante" ou "effet de vanne de spin" (en anglais "giant magnetoresistance" ou "spin-valve effect").

Dans les magnétorésistances de type à vanne de spin, la couche ferromagnétique sensible, c'est-à-dire à aimantation libre, présente une épaisseur comprise entre 6 à 12 nm pour avoir une amplitude de magnétorésistance maximum. En-dessous de 6 nm, ces magnétorésistances ont une amplitude de réponse qui diminue fortement. Aussi, ce type de magnétorésistance est limité en sensibilité pour les faibles quantité de flux.

Le document (1) dont la référence est indiquée à la fin de la présente description décrit de façon très générale l'usage de cet effet de magnétorésistance géante pour la réalisation de capteurs de champ magnétique.

On sait enfin qu'un effet de magnétorésistance existe dans des jonctions à effet tunnel du type métal-isolant-métal dans lesquelles une couche mince d'isolant, formant une barrière de potentiel pour les électrons de conduction, est disposée entre deux couches de métal magnétique.

Le métal magnétique est choisi, par exemple, parmi Fe, Co, Ni ou leurs alliages et la couche d'isolant, d'une épaisseur de quelques nanomètres, est en un matériau choisi, par exemple, parmi $Al_2O_3$, MgO, AlN, $Ta_2O_5$, $HfO_2$, NiO.

Dans ce type de jonction, lorsqu'on force des électrons à passer par effet tunnel à travers la barrière, en connectant la jonction à une source de courant ou en appliquant une tension entre les deux couches de métal magnétique, on observe que la conductance G de la jonction varie en fonction de l'orientation relative des aimantations des couches de matériau magnétique de part et d'autre de la barrière formée par la couche isolante (à la manière d'un système polariseur-analyseur optique).

Cet effet, appelé "effet de vanne magnétique", n'était d'abord observé qu'à basse température et son amplitude était très faible.

Des structures particulières de type matériau magnétique/isolant/matériau magnétique avec des jonctions de la forme Fe/Al/Al$_2$O$_3$/FeCo ont permis cependant d'obtenir des variations de la conductance, à température ambiante, et avec une amplitude de l'ordre de 17%.

Des structures à effet de vanne magnétique sont décrites, par exemple, dans les documents (2), (3), et (4). De même, des expériences concernant des jonctions à effet tunnel sont décrites dans les documents (5) et (6). Les références de ces documents sont précisées à la fin de la présente description.

Récemment, des progrès importants ont été réalisés pour l'élaboration des jonctions et en particulier en ce qui concerne le contrôle de la qualité de la barrière isolante.

La barrière isolante est réalisée, par exemple, en déposant une fine couche d'aluminium sur l'une des électrodes métalliques de la jonction puis en oxydant la couche d'aluminium par un plasma d'oxygène.

La durée de l'oxydation par le plasma d'oxygène permet ainsi de contrôler l'épaisseur et donc la résistance électrique de la barrière isolante.

Il est possible également de laisser la couche d'aluminium s'oxyder à l'air. Les résultats et la qualité de la barrière isolante sont alors moins reproductibles.

Dans les jonctions à effet de vanne magnétique avec une structure de type matériau magnétique-oxyde-matériau magnétique, notée M-O-M', on choisit les matériaux magnétiques de telle sorte que l'aimantation d'une des couches magnétiques (par exemple M'a) reste fixe dans une direction donnée, dans la gamme de champs à mesurer, alors que l'aimantation de l'autre couche (M dans cet exemple) est capable de suivre les variations du champ appliqué. La première couche est appelée "couche piégée", tandis que la deuxième est appelée "couche sensible". L'intérêt des jonctions à vanne magnétique par rapport aux structures de vanne de spin, est d'offrir des amplitudes de mesure plus importantes (17% au lieu de 5 à 9%).

Le document (10), dont la référence est précisée à la fin de la description, décrit une magnétorésistance avec une couche à aimantation libre et une couche à aimantation piégée.

Exposé de l'invention

L'invention a pour but de proposer une magnétorésistance à effet tunnel telle que décrite ci-dessus présentant une plus forte amplitude de variation de la conductance.

Un but est également de proposer des magnétorésistances avec une sensibilité accrue et présentant des dimensions réduites.

Un but de l'invention est encore de proposer un capteur magnétique, notamment pour l'enregistrement magnétique à très haute densité (supérieure à 10 Gbit/inch$^2$), permettant de lire les informations à partir de très petites quantités de flux magnétique.

Pour atteindre ces buts, la présente invention a plus précisément pour objet une magnétorésistance à effet tunnel comportant, sous la forme d'un empilement :

- une première couche de matériau magnétique à aimantation libre,
- une couche, dite de barrière, en un matériau isolant électrique, et
- une deuxième couche de matériau magnétique à aimantation piégée.

Conformément à l'invention, la première couche de matériau magnétique présente une épaisseur inférieure ou égale à 7 nm.

Une sensibilité particulièrement bonne de la magnétorésistance peut être obtenue lorsque la première couche de matériau magnétique présente une épaisseur comprise entre 0,2 nm et 2 nm.

Grâce à la très faible épaisseur notamment de la première couche de matériau magnétique, la magnétorésistance présente des variations de conductance de forte amplitude pour de faibles valeurs de variation du flux magnétique qui lui est appliqué.

Une telle magnétorésistance est ainsi adaptée à la lecture de données sur des supports de données, tels que des disques durs, avec une grande densité d'information. En effet, plus la densité d'information stockée sur un disque dur est importante, plus la quantité de flux $\phi$ magnétique émanant des transitions magnétiques entre deux bits d'information adjacents, captée par une tête de lecture, est faible. Or, ce flux magnétique provoque une rotation $\Delta\theta$ de l'aimantation de la couche magnétique sensible donnée par $\phi \approx$ LL. E$_{Em}$.$\Delta\theta$. Dans cette expression, Le représente la section de la couche magnétique sensible dans laquelle pénètre le flux magnétique $\phi$, e est l'épaisseur de cette couche sensible et Ms est son aimantation spontanée. De l'expression ci-dessus, il ressort qu'à quantité de flux $\phi$ égale, plus l'épaisseur e de la couche sensible est fine, plus la rotation $\Delta\theta$ de son aimantation est importante.

La conductance G($\Delta\theta$) de la jonction varie suivant la formule :

$$G(\Delta\theta) = G_{antiparallèle} + \left(G_{parallèle} - G_{antiparallèle}\right)\left(\frac{1 + \cos(\Delta\theta)}{2}\right)$$

Dans cette formule $P_{arallèle}$ et $A_{ntiparallèle}$ représentent respectivement les conductances dans les configurations magnétiques parallèle et antiparallèle. Il apparaît que plus $\Delta\theta$ est grand, plus la variation de conductance est importante et donc plus la sensibilité du capteur est importante.

A titre de comparaison avec les structures classiques connues, il convient de préciser que dans les capteurs magnétorésistifs métalliques basés sur l'effet d'anisotropie de la magnétorésistance, dits AMR, l'épaisseur de la couche sensible est d'au moins 15 nm. Dans de tels capteurs, il n'est pas possible de réduire beaucoup l'épaisseur de la couche sensible. En effet, dans les capteurs AMR, l'amplitude de l'effet de variation de conductance chute fortement lorsque la couche sensible présente une épaisseur inférieure à 20 nm. De la même façon, les électrodes utilisées dans les jonctions à effet tunnel, telles que décrites dans les documents (5) et (6), par exemple, présentent des épaisseurs importantes, supérieures à 30 nm.

Selon un aspect particulier de l'invention, la deuxième couche magnétique, à aimantation piégée, peut être réalisée avec une épaisseur comparable à celle de la première couche magnétique. Son épaisseur est, par exemple, comprise entre 0,4 et 2 nm.

Lorsque la deuxième couche magnétique est fine, les interactions magnétostatiques entre la deuxième couche, dont l'aimantation est piégée, et la première couche, dont l'aimantation est libre, sont faibles. Ainsi, la première couche magnétique n'est pas influencée et conserve mieux sa propriété d'aimantation libre, même dans des structures de magnétorésistance de très faibles dimensions.

Selon un autre aspect de l'invention, la magnétorésistance peut comporter, en outre, une couche de métal non ferromagnétique (NM) entre la première couche de matériau magnétique (M) et la barrière isolante (O). Le rôle de cette couche NM est de constituer un revêtement antireflet pour une catégorie seulement d'électrons de conduction (soit ceux de spin parallèle à l'aimantation de la couche M, soit ceux de spin antiparallèle à l'aimantation de M). Il en résulte une forte augmentation de la polarisation effective des électrons qui traversent par effet tunnel la barrière isolante et par là-même, une amplitude de magnétorésistance supérieure. Cet effet est décrit d'un point de vue théorique dans le document (7). L'origine physique de cet effet antireflet dépendant du spin est la même que celle qui donne naissance aux oscillations de couplage magnétique à travers des couches non ferromagnétiques observées dans des structures multicouches de période (M/NM) lorsque l'épaisseur des couches NM varie. Elle réside dans le fait que les coefficients de réflexion des électrons aux interfaces M/NM dépendent du spin de l'électron relativement à l'aimantation de la couche M. On peut se reporter à ce sujet aux documents (8) et (9) cités à la fin de la présente description. En conséquence, pour bénéficier de cet effet antiréfléchissant sélectif en spin dans les jonctions tunnel de l'invention, il convient de choisir le couple métal magnétique/métal non ferromagnétique de sorte que les multicouches correspondantes de période (M/NM) présentent des oscillations de couplage en fonction de l'épaisseur des couches NM. Une importante littérature existe aujourd'hui sur ces multicouches à oscillations de couplage (voir par exemple le document (8)). Cette littérature peut servir de base de données pour le choix des matériaux M/NM. Un choix particulièrement approprié pour les jonctions tunnel est d'utiliser une couche de métal magnétique en Co ou alliages $Co_{1-x}Fe_x$ riche en Co (x de 0 à 50%) et pour la couche non ferromagnétique une couche de Cu. Les multicouches (Co/Cu) sont en effet connues pour présenter d'importantes oscillations de couplage à travers le Cu. D'autres exemples de choix de couples (N, NM) possibles sont (Fe, Cr), (Co, Ru), (Fe, Au). L'épaisseur de la couche NM peut varier de 0 à environ 10 nm et de préférence de 0,4 à 3 nm.

Ces couches antiréfléchissantes NM peuvent avantageusement être intercalées de part et d'autre de la barrière isolante O entre les couches magnétiques et la barrière isolante.

La magnétorésistance peut également comporter au moins une couche de matériau magnétique, dite couche dopante, intercalée à l'interface entre la couche magnétique M et la couche NM ou à défaut de couche NM entre M et la barrière isolante O.

Les couches dopantes sont des couches très fines qui permettent d'augmenter la polarisation des électrons qui traversent la couche de barrière par effet tunnel.

Elles peuvent être réalisées en cobalt, en fer ou encore en alliage $Co_{1-x}Fe_x$ où x est un paramètre compris entre 0 et 1. Eventuellement, les couches dopantes peuvent contenir d'autres éléments, tels que du nickel, en faible quantité.

L'invention a également pour objet un capteur magnétique, par exemple pour la lecture de données, comportant une ou plusieurs magnétorésistances telles que décrites ci-dessus.

D'autres caractéristiques et avantages de l'invention ressortiront mieux de la description qui suit, en référence aux figures des dessins annexés. Cette description est donnée à titre purement illustratif et non limitatif.

Brève description des figures

- La figure 1 est une coupe schématique d'une magnétorésistance conforme à la présente invention.
- La figure 2 est une représentation schématique des orientations des aimantations des couches magnétiques de la magnétorésistance de la figure 1.
- Les figures 3, 4 et 5 sont des graphiques indiquant l'amplitude de réponse de la magnétorésistance en fonction de l'épaisseur d'une couche magnétique à aimantation libre de la magnétorésistance.

Description détaillée de modes de réalisation de l'invention

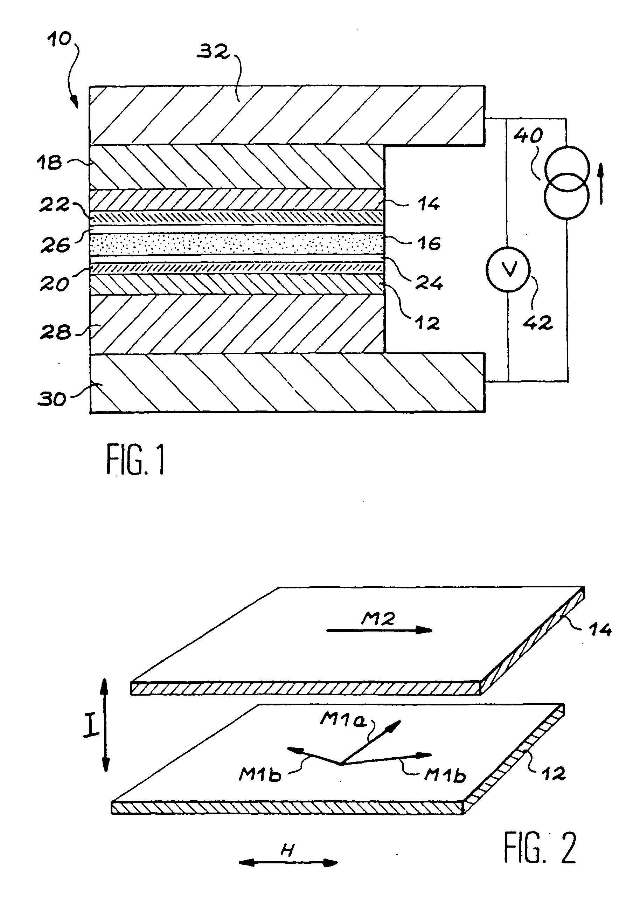

Avant de décrire la figure 1, il convient de préciser que cette figure n'est pas une représentation à l'échelle d'une magnétorésistance conforme à l'invention. En effet, pour des raisons de clarté, l'épaisseur de certaines parties est exagérée.

La magnétorésistance 10 de la figure 1 comporte pour l'essentiel une première couche de matériau magnétique 12, à aimantation libre, une deuxième couche de matériau magnétique 14, à aimantation piégée, et une couche 16, dite de barrière, en un matériau isolant électrique, qui sépare les première et deuxième couches de matériau magnétique.

La première couche de matériau magnétique 12 est la couche sensible de la magnétorésistance. Elle est réalisée en un matériau magnétiquement doux, tel que le Permalloy par exemple. Son aimantation répond ainsi facilement aux variations d'un champ magnétique extérieur qui y est appliqué.

Conformément à l'invention, cette couche est très fine de sorte que son aimantation puisse tourner de façon importante sous l'effet de faibles flux magnétiques. L'épaisseur de la première couche magnétique 12 est, comme indiqué précédemment, choisie de préférence entre 0,2 et 2 nm.

La deuxième couche de matériau magnétique 14 présente une aimantation piégée, par exemple par anisotropie d'échange avec une couche antiferromagnétique, de préférence métallique.

Dans l'exemple de la figure 1, la deuxième couche de matériau magnétique est en contact et couplée avec une couche 18 de piégeage en un alliage antiferromagnétique. Parmi les matériaux utilisables pour réaliser la couche de piégeage, on peut retenir, par exemple, les alliages suivants : FeMn, IrMn, CrMn, CrPtMn, IrCrMn, PtMn, NiMn.

Le matériau magnétique de la deuxième couche 14 peut être choisi parmi Fe, Co, Ni et alliages. $Fe_{1-x-y}Co_xNi_y$ de préférence riche en Fe ou en Co (y entre 0 et 30%, x entre 0 et 100%).

Par ailleurs, la deuxième couche 14 est réalisée préférentiellement avec une épaisseur comprise entre 0,4 et 2 nm.

Le fait de réaliser une deuxième couche 14 fine présente l'avantage de favoriser le piégeage de l'aimantation par anisotropie d'échange (couplage avec la couche antiferromagnétique 18). En effet, le champ magnétique de piégeage est fonction de l'inverse de l'épaisseur de la couche piégée. Ainsi, une couche fine aura un champ de piégeage supérieur à une couche plus épaisse.

Un autre avantage lié à la faible épaisseur de la deuxième couche magnétique 14 est qu'un champ de fuite, qui peut exister entre les bords de cette couche, se trouve réduit.

La réduction de ce champ de fuite permet d'éviter un couplage parasite magnétostatique entre les première et deuxième couches magnétiques et de conserver ainsi le caractère magnétiquement doux de la première couche 12 de matériau magnétique même dans un dispositif de dimension latérale réduite (dimension de l'ordre du micron).

La couche de barrière 16 est une fine couche de matériau isolant électrique tel que l'alumine par exemple. Son épaisseur est comprise de préférence entre 0,5 nm et quelques nanomètres. La couche de barrière peut être obtenue en oxydant une couche d'aluminium avec un plasma d'oxygène.

La référence 20 désigne une fine couche en un matériau tel que Fe, Co ou un alliage Co-Fe, qui est disposée entre la première couche 12 de matériau magnétique et la couche de barrière 16. Cette fine couche 20, encore appelée couche dopante, permet d'augmenter la polarisation des électrons qui traversent la couche de barrière par effet tunnel. L'épaisseur de la couche dopante 20 est comprise de préférence entre 0,1 et 0,4 nm.

Une autre couche dopante 22, équivalente à la couche dopante 20, mentionnée ci-dessus, est également prévue entre la deuxième couche de matériau magnétique 14 et la couche de barrière.

La référence 24 de la figure 1 désigne une couche métallique non-ferromagnétique, telle qu'une couche de Cu, disposée entre la couche dopante 20 de la première couche 12 de matériau magnétique, et la couche de barrière 16 isolante. La couche non-ferromagnétique présenté une épaisseur qui peut varier de 0 à quelques nanomètres. Elle joue le rôle de couche antireflet sélective en spin telle qu'évoquée précédemment. Une autre couche 26, équivalente à la couche non ferromagnétique 24, peut être avantageusement insérée entre la couche de barrière isolante 16 et la couche dopante 22.

Une première couche conductrice 30 et une deuxième couche conductrice 32 sont prévues pour amener un courant de mesure aux bornes de la magnétorésistance. Ces couches conductrices sont respectivement en contact électrique avec les première et deuxième couches de matériau magnétique.

La première couche de matériau magnétique 12 est connectée à la première couche conductrice d'amenée de courant 30 par l'intermédiaire d'une (ou plusieurs) couche tampon 28, électriquement conductrices. La couche tampon 28 peut être, par exemple, en un matériau choisi parmi Ti, V, Cr, Co, Nb, Ru, Ta et W. Le rôle de la couche tampon est lié à la fabrication de la magnétorésistance. Elle est en effet destinée à promouvoir la bonne croissance des autres couches de la magnétorésistance.

La couche tampon 28 présente une épaisseur de l'ordre de un à quelques nanomètres. Cette épaisseur est de préférence faible afin de ne pas augmenter l'épaisseur totale de la magnétorésistance et ainsi de ne pas augmenter la distance entre les pôles magnétiques (bornes) de la magnétorésistance. Ceci est avantageux en particulier pour obtenir des têtes de lecture de pistes magnétiques avec une bonne résolution linéaire.

La deuxième couche conductrice d'amenée de courant 32 est connectée à la deuxième couche 14 de matériau magnétique par l'intermédiaire de la couche de piégeage 18.

Lorsque la magnétorésistance est destinée à être utilisée comme capteur dans une tête de lecture de pistes magnétiques, les écrans magnétiques habituellement présents dans les têtes dites "verticales" bien connue de l'homme de l'art, peuvent être avantageusement utilisées comme couches conductrices d'amenées de courant 30, 32. Ces écrans sont souvent réalisés en Permalloy ou en alliages CoZrB.

Les références 40 et 42 désignent respectivement un générateur de courant et un dispositif de mesure des variations du courant. Ces appareils sont montés entre les couches d'amenée de courant 30, 32.

Le générateur de courant 40 permet de faire circuler à travers la magnétorésistance un courant de mesure sensiblement perpendiculaire à l'empilement des couches. Par ailleurs, le dispositif de mesure 42 permet d'enregistrer les variations de tension aux bornes de l'élément magnétorésistif, partant de la conductance de la magnétorésistance, en réponse aux variations d'un champ magnétique extérieur détecté.

La figure 1 ne représente qu'une réalisation particulière d'une magnétorésistance conforme à l'invention. D'autres réalisations sont envisageables. Par exemple, l'ordre des couches pourrait aussi être le suivant : couche d'amenée de courant, couche tampon, couche antiferromagnétique de piégeage de l'aimantation, couche magnétique fine à aimantation piégée, couche dopante, couche antiréfléchissante, barrière isolante, couche antiréfléchissante, couche dopante, couche magnétique à aimantation libre, couche d'amenée de courant.

Dans ces structures certaines couches, telles que par exemple les couches dopantes, les couches antiréfléchissantes, ou les couches tampon ne sont pas indispensables. De la même façon, le piégeage de l'aimantation de la deuxième couche magnétique peut être obtenu sans avoir recours à une couche de matériau antiferromagnétique de piégeage.

Par exemple, la deuxième couche de matériau magnétique peut être une couche fortement coercitive du type aimant permanent, ou une couche d'alliage avec une composition voisine de $Co_{50}Fe_{50}$.

D'autres procédés de piégeage utilisés dans les structures de type vanne de spin peuvent également être retenus. A titre d'exemple, la deuxième couche de matériau magnétique à aimantation piégée peut être formée de deux couches magnétiques à couplage antiferromagnétique du type Co-Ru-Co, l'épaisseur de ces couches étant par exemple 1 nm ; 0,4 nm et 1 nm.

Sur la figure 2, seules les première et deuxième couches de matériau magnétique 12, 14 sont représentées. On désigne par I le courant de mesure circulant par effet tunnel à travers la barrière isolante entre les couches de matériau magnétique. Ce courant est représenté par une double flèche. De la même façon, une double flèche représente un champ extérieur H appliqué à la magnétorésistance.

L'aimantation, piégée, de la deuxième couche 14 de matériau magnétique est indiquée par une flèche $M_2$. Dans l'exemple illustré, la magnétorésistance est orientée de telle façon que l'aimantation piégée $M_2$ soit sensiblement parallèle au champ H extérieur.

L'aimantation de la première couche 12 de matériau magnétique doux est libre.

Une flèche $M_{1a}$ indique l'orientation de l'aimantation de la première couche 12 en l'absence de champ extérieur appliqué. Cette orientation correspond à un axe d'aimantation facile de la couche de matériau magnétiquement doux.

Par construction, les première et deuxième couches de matériau magnétique sont agencées de façon que l'axe d'aimantation facile de la première couche 12 de matériau magnétique soit sensiblement perpendiculaire à la direction de piégeage de l'aimantation de la deuxième couche 14 de matériau magnétique.

Lorsque le champ magnétique H est appliqué à la magnétorésistance, l'aimantation de la première couche magnétique 12 change d'orientation. L'aimantation de cette couche vient s'aligner selon une direction parallèle ou antiparallèle à l'aimantation de la deuxième couche magnétique 14 lorsque le champ magnétique appliqué atteint une valeur de saturation.

L'aimantation de la première couche magnétique en présence du champ H est indiquée avec des flèches $M_{1b}$. Si le champ extérieur est appliqué dans le sens de $M_2$, les aimantations $M_{1b}$ et $M_2$ tendent à devenir parallèles.

Si le champ extérieur est appliqué en sens opposé à $M_2$, les aimantations $M_{1b}$ et $M_2$ deviennent antiparallèles.

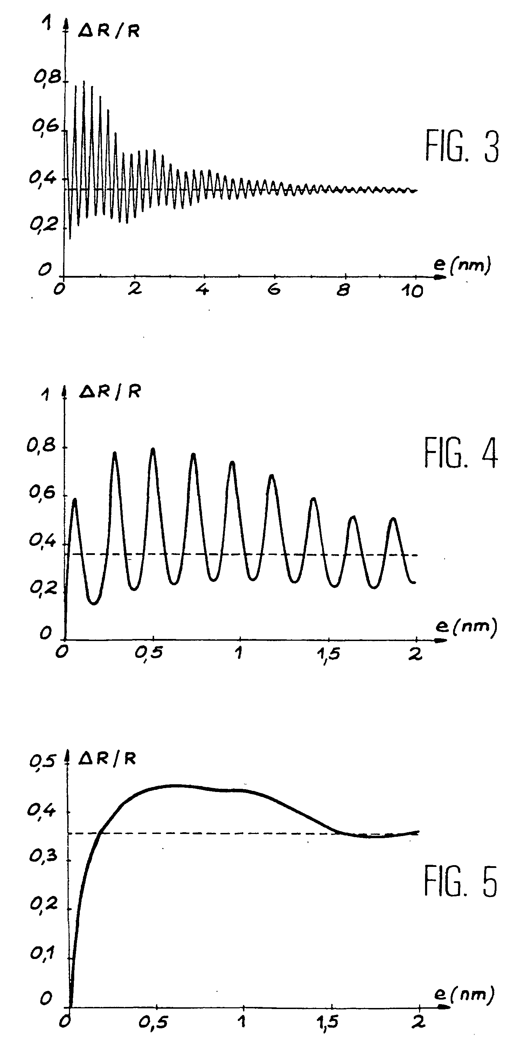

Les figures 3, 4 et 5 sont des graphiques exprimant en ordonnée la variation relative de la conductance $\frac{\Delta R}{R}$ en fonction de l'épaisseur des couches de matériau magnétique 12. Cette épaisseur est donnée en nanomètres.

Ces graphiques sont établis par calcul pour une magnétorésistance conforme à l'invention avec la structure suivante : une couche de métal non-magnétique (semi-infinie), une couche de matériau magnétique, une couche de barrière d'oxyde, une couche de matériau magnétique et une couche de métal non-magnétique (semi-infinie).

En désignant par k les vecteurs d'onde aux niveaux de Fermi des matériaux utilisés et par ↑ et ↓ le spin des électrons, les paramètres pour établir les graphiques sont les suivants :

- pour les couches non-magnétiques : $k\uparrow=k\downarrow=1\text{Å}^{-1}$,
- pour les couches magnétiques : $k\uparrow=0,2\text{A}^{-1}$, $k\downarrow=1, 4\text{Å}^{-1}$,
- pour la barrière d'oxyde isolante : $k\uparrow=k\downarrow=1i\text{A}^{-1}$.

Les vecteurs d'onde sont réels dans les métaux et imaginaires dans l'isolant (onde évanescente). Les valeurs de paramètres choisis pour les couches magnétiques correspondent à une polarisation des électrons tunnel de 42%. Cette polarisation est très proche de celle mesurée dans le fer (40%).

La figure 3 représente la variation de magnétorésistance de la jonction lorsque l'épaisseur des couches magnétiques 12 varie de 0 à 10 nm. La ligne en pointillé correspond à la valeur asymptotique de la magnétorésistance obtenue lorsque l'épaisseur des couches magnétiques tend vers l'infini.

On voit sur cette figure que le maximum d'amplitude est obtenu pour des couches 12 d'épaisseur inférieure à 2 nm. Cette amplitude diminue progressivement jusqu'à atteindre une valeur asymptotique pour une épaisseur de l'ordre de 7 nm. Selon l'invention, la première couche magnétique 12 est donc choisie avec une épaisseur inférieure ou égale à 7 nm.

La figure 4 est une vue agrandie de la figure 3 pour une épaisseur de couche magnétique variant de 0 à 2 nm. Les oscillations sont dues à des effets d'interférences quantiques liées à des réflexions se produisant aux interfaces métal non-magnétique-métal magnétique et métal magnétique-barrière d'oxyde isolante.

Ces effets d'interférence peuvent disparaître dans des jonctions réelles qui présentent une certaine rugosité aux interfaces entre les couches.

La figure 5 indique les variations de magnétorésistance en fonction de l'épaisseur des couches magnétiques en tenant compte d'une rugosité de 0,2 nm aux interfaces métal non-magnétique/métal magnétique et métal magnétique/oxyde. Cette rugosité conduit à des fluctuations spatiales d'épaisseur des couches magnétiques, ce qui revient à filtrer les oscillations quantiques de la figure 4 pour n'en garder que la variation moyenne. Le point majeur, néanmoins, est que de très fines couches magnétiques suffisent à produire l'effet de magnétorésistance dans ces jonctions magnétiques.

Les courbes sont calculées selon un modèle théorique expliqué dans le document (7) dont la référence est précisée ci-après.

Ainsi, les magnétorésistances selon l'invention permettent, par la diminution de l'épaisseur de la couche à aimantation libre, par rapport à des magnétorésistances classiques pour un flux magnétique donné, d'obtenir des sensibilités de magnétorésistances plus importantes.

DOCUMENT CITES

*(1)* US-A-4 949 039

*(2)* PHYSICAL REVIEW B, vol. 39, N°10, 1 Avril 1989, "Conductance and exchange coupling of two ferromagnets separated by a tunneling barrier" de J.C. Slonczewski

*(3)* Journal of Magnetism and Magnetic Materials 109 (1992) 79-90,
"Spin dependent electron tunneling between ferromagnetic films"
de J. Nowak and J. Rauluszkiewics

*(4)* PHYSICAL REVIEW LETTERS, vol. 74, n° 16, 17 Avril 1995
"Large magnetoresistance at Room Temperature in Ferromagnetic Thin Film Tunnel Junctions"
de J.S. Moodera et al.

*(5)* Journal of Magnetism and Magnetic Materials 139 (1995) L231-L234
"Giant magnetic tunneling effect in $Fe/Al_2O_3/Fe$ junction"
de T. Miyazaki, N. Tezuka et al.

*(6)* J. Appl. Phys. 79(8), 15 Avril 1996,
Symposium on Spin Tunneling and Injection Phenomena "Ferromagnetic-insulator-ferromagnetic tunneling : Spin-dependent tunneling and large magnetoresistance in trilayer junctions"
de Jagadeesh S. Moodera and lisa R. Kinder
**(7)** Europhysics Letters, Europhys. Lett. 39(2), pp. 219-224 (1997, 15 July 1997
"Resonance in tunneling through magnetic valve tunnel junctions"
de A. Vedyayev et al.
**(8)** Eds B. Heinrich and J.A. C. Bland (Springer-Verlag, Berlin 1994, 82)
"Ultrathin Magnetic Structures II, Measurement Techniques and Magnetic Properties",
A. Fert et P. Bruno, (1994)
**(9)** Journ. Magn. Magn. Mater. 121, 248 (1993)
"Interlayer exchange coupling : a unified physical picture",
P. Bruno
**(10)** US-A-5 650 958

**Revendications**

1.  Magnétorésistance à effet tunnel comportant, sous la forme d'un empilement :

    -   une première couche (12) de matériau magnétique à aimantation libre,
    -   une couche (16), dite de barrière, en un matériau isolant électrique, et
    -   une deuxième couche (14) de matériau magnétique à aimantation piégée,

    **caractérisée en ce que** la première couche (12) de matériau magnétique présente une épaisseur inférieure ou égale à 7 nm.

2.  Magnétorésistance selon la revendication 1, dans laquelle la première couche (12) de matériau magnétique présente une épaisseur comprise entre 0,2 nm et 2 nm.

3.  Magnétorésistance selon la revendication 1, dans laquelle la deuxième couche (14) de matériau magnétique présente une épaisseur comprise entre 0,4 et 2 nm.

4.  Magnétorésistance selon la revendication 1, comportant en outre une couche (24) de métal non ferromagnétique disposée entre la première couche de matériau magnétique et la couche de barrière isolante.

5.  Magnétorésistance selon la revendication 1, comportant en outre une couche (26) de métal non ferromagnétique disposée entre la couche de barrière isolante et la deuxième couche de matériau magnétique.

6.  Magnétorésistance selon la revendication 1 comportant en outre au moins une couche de matériau magnétique (20, 22) dite couche dopante, en contact respectivement avec au moins l'une des première et deuxième couches de matériau magnétique.

7.  Magnétorésistance selon la revendication 6, dans laquelle la couche dopante (20, 22) est une couche en un alliage $Co_{1-x}Fe_x$, avec $0 \leq x \leq 1$.

8.  Magnétorésistance selon la revendication 1, comprenant en outre une couche de matériau antiferromagnétique (18) en contact avec la deuxième couche de matériau magnétique (14) pour piéger l'aimantation de cette deuxième couche.

9.  Magnétorésistance selon la revendication 1, comprenant en outre deux couches d'amenée de courant (30, 32), en contact électrique respectivement avec la première (12) et la deuxième (14) couches de matériau magnétique.

10. Magnétorésistance selon la revendication 9, comportant en outre au moins une couche métallique (26), dite couche tampon, entre la première couche de matériau magnétique (12) et la couche d'amenée de courant (30) en contact électrique avec cette première couche.

11. Capteur magnétique comprenant au moins une magnétorésistance conforme à l'une quelconque des revendications précédentes.

**Patentansprüche**

1. Tunneleffekt-Magnetowiderstand, in Form eines Stapels, umfassend:

   - eine erste Schicht (12) aus magnetischem Material mit freier Magnetisierung,
   - eine Schicht (16), Barrierenschicht genannt, aus einem elektrisch isolierenden Material, und
   - eine zweite Schicht (14) aus magnetischem Material mit festgelegter Magnetisierung bzw. Magnetisierungsrichtung,

   **dadurch gekennzeichnet,**
   **dass** die erste Schicht (12) aus magnetischem Material eine Dicke unter oder gleich 7 nm aufweist.

2. Magnetowiderstand nach Anspruch 1, bei dem die erste Schicht (12) aus magnetischem Material eine zwischen 0,2 nm und 2 nm enthaltene Dicke aufweist.

3. Magnetowiderstand nach Anspruch 1, bei dem die zweite Schicht (14) aus magnetischem Material eine zwischen 0,4 und 2 nm enthaltene Dicke aufweist.

4. Magnetowiderstand nach Anspruch 1, der außerdem eine Schicht (24) aus nicht-ferromagnetischem Metall umfasst, angeordnet zwischen der ersten Schicht aus magnetischem Material und der isolierenden Barrierenschicht.

5. Magnetowiderstand nach Anspruch 1, der außerdem eine Schicht (26) aus nicht-ferromagnetischem Metall umfasst, angeordnet zwischen der isolierenden Barrierenschicht und der zweiten Schicht aus magnetischem Material.

6. Magnetowiderstand nach Anspruch 1, der außerdem eine Schicht aus magnetischem Material (20, 22) umfasst, dotierende Schicht genannt, die sich jeweils in Kontakt mit wenigstens einer der beiden Schichten, der ersten bzw. der zweiten aus magnetischem Material befindet.

7. Magnetowiderstand nach Anspruch 6, bei dem die dotierende Schicht (20, 22) eine Schicht aus einer $Co_{1-x}Fe_x$-Legierung ist, mit $0 \leq x \leq 1$.

8. Magnetowiderstand nach Anspruch 1, der außerdem eine Schicht aus einem antiferromagnetischen Material (18) umfasst, das Kontakt hat mit der zweiten Schicht aus magnetischem Material (14), um die Magnetisierung bzw. Magnetisierungsrichtung dieser zweiten Schicht festzulegen.

9. Magnetowiderstand nach Anspruch 1, der außerdem zwei Stromzuführungsschichten (30, 32) umfasst, jeweils mit elektrischem Kontakt mit der ersten (12) beziehungsweise der zweiten (14) Schicht aus magnetischem Material.

10. Magnetowiderstand nach Anspruch 9, der außerdem wenigstens eine Pufferschicht genannte, metallische Schicht (26) umfasst, zwischen der ersten Schicht aus magnetischem Material (12) und der Stromzuführungsschicht (30) mit elektrischem Kontakt mit dieser ersten Schicht.

11. Magnetischer Sensor mit wenigstens einem Magnetowiderstand nach einem der vorhergehenden Ansprüche.

**Claims**

1. Tunnel effect magnetoresistance comprising, in the form of a stack:

   - a first layer (12) of free magnetisation magnetic material,
   - a "barrier" layer (16), composed of an electrically insulating material, and
   - a second layer (14) of trapped magnetisation magnetic material,

     **characterised in that** the thickness of the first layer (12) of magnetic material is less than or equal to 7 nm.

2. Magnetoresistance according to claim 1, wherein the thickness of the first layer (12) of magnetic material is between 0.2 nm and 2 nm.

3. Magnetoresistance according to claim 1, wherein the thickness of the second layer (14) of magnetic material is between 0.4 nm and 2 nm.

4. Magnetoresistance according to claim 1, also comprising a layer (24) of non-ferromagnetic metal inserted between the first layer of magnetic material and the insulating barrier layer.

5. Magnetoresistance according to claim 1, also comprising a layer (26) of non-ferromagnetic metal inserted between the insulating barrier layer and the second layer of magnetic material.

6. Magnetoresistance according to claim 1, also comprising at least one layer of magnetic material (20, 22), or doping layer, in contact with at least one of the first and second layers of magnetic material, respectively.

7. Magnetoresistance according to claim 6, wherein the doping layer (20, 22) is a layer composed of a $Co_{1-x}Fe_x$ alloy, where $0 \leq x \leq 1$.

8. Magnetoresistance according to claim 1, also comprising a layer of anti-ferromagnetic material (18) in contact with the second layer of magnetic material (14) to trap the magnetisation of said second layer.

9. Magnetoresistance according to claim 1, also comprising two current supply layers (30, 32) in electrical contact with the first (12) and second (14) layers of magnetic material, respectively.

10. Magnetoresistance according to claim 9, also comprising at least one metal layer (26), or buffer layer, between the first layer of magnetic material (12) and the current supply layer (30) in electrical contact with said first layer.

11. Magnetic sensor comprising at least one magnetoresistance according to any of the preceding claims.

FIG. 1

FIG. 2

FIG. 3

FIG. 4

FIG. 5